# EUROPEAN PATENT SPECIFICATION

(11) **EP 0 299 163 B1**
(45) Date of publication and mention of the grant of the patent: **15.12.1993**
(21) Application number: 88107375.3
(22) Date of filing: 07.05.1988
(51) Int. Cl.: H01L 23/52, H01L 21/90, H01L 39/24

(54) **Interconnection method for semiconductor device**
Verbindungsverfahren für Halbleiteranordnung
Procédé d'interconnexion pour dispositif semi-conducteur

(30) Priority: 15.07.1987 JP 176220/87
(43) Date of publication of application: 18.01.1989
(73) Proprietor: SHARP KABUSHIKI KAISHA, Osaka 545 (JP)
(72) Inventor: Nakagawa, Yasuhito, Nara-shi Nara-ken (JP)
(74) Representative: von Kreisler, Alek, Dipl.-Chem.

(56) References cited:
- EP-A- 0 285 106
- EP-A- 0 286 106
- EP-A- 0 295 708
- WO-A-88/10011
- US-A- 4 507 852
- NEW ELECTRONICS, 12th May 1987, page 30; P. JUDGE: "Superconductor future heats up"
- PATENT ABSTRACTS OF JAPAN, vol. 9, no. 321 (E-367)[2044], 17th December 1985 & JP-A-60 154 613
- IEEE TRANSACTIONS ON MAGNETICS, vol. MAG-23, no. 2, March 1987, pages 641-648, IEEE, New York, US; K. TACHIKAWA et al.: "Laser and electron beam processing of superconductors"
- JAPANESE JOURNAL OF APPLIED PHYSICS/PART 2: LETTERS, vol. 27, no. 2, February 1988, pages L231-L233, Tokyo, JP; N. AIZAKI et al.: "YBa2Cu3Oy superconducting thin film obtained by laser annealing"

## Description

The present invention generally relates to a method of forming an interconnection wiring of a semiconductor device and more particularly, to an improvement on a interconnection for a semiconductor device.

Recently, there has been a remarkable progress in the field of a semiconductor technique, particularly, with respect to DRAM (Dynamic random access memory) which leads the silicon (Si) LSI (Large scale integration) technique, and a 4M DRAM is to be put into actual application before long. Such VLSI is based on a MOS (Metal Oxide Semiconductor) device, using a process technology in the order of about 2 µm to 1 µm as a level for fine-pattern fabrication technology, and a technology in a sub-micron region has already been brought into a vigorous discussion. The fine-pattern fabrication technology processing, which has been pursued as means for realizing higher integration and higher density, has inevitably brought about higher performance and higher speed of the MOS device, and gate delay time below 1 ns which was conventionally considered to be realized by only bi-polar devices, is now at the stage of actual application. However, as the delay time of a MOS device, there may be raised delay time at input/output portions, delay time at interconnection, etc., besides the gate delay time, and especially, the delay time at the interconnection is increasing with the increase in the chip dimensions following the larger integration, thus hindering the effective reduction reduction of the total delay time for the MOS device.

Similar problems as referred to above are also present in a GaAs LSI expected for functioning at a speed higher than that in the Si LSI. Meanwhile, since the GaAs LSI is to be driven at a lower voltage and a larger current than in the Si LSI, potential rising or falling on the interconnection due to the interconnection resistance (particularly, in the interconnection such as a power source line, etc. through which a large current flows) tends to occur, thus resulting in the deterioration of various characteristics.

Accordingly, investigation has been started into replacement of the interconnection material, from metal to a superconductive substance in which electrical resistance is reduced to zero under certain conditions.

The material currently studied for use as the interconnection material of a semiconductor is a high-temperature super-conductive material (e.g. of Y-Ba-Cu-O group, etc.) having a critical temperature in which electrical resistance becomes 0, in the vicinity of the temperature of liquid nitrogen (77 K) or in a temperature region higher than that.

However, the high-temperature superconductive material as referred to above does not generally show superconductive characteristics unless it is subjected to sintering for several hours at high temperatures close to 1000°C, and since active elements such as transistors have already been formed on a semiconductor substrate, heat treatment at such a high temperature can not be effected, because the transistors, etc. are deteriorated or destroyed by the heat.

More specifically, in order to form interconnection of a semiconductor device by a high-temperature superconductive material for the interconnection resistance to 0, it is necessary to lower the heat treating temperature of the material at the vapor deposition or thereafter (It is preferable that the heat treating temperature should be lowered to about 400°C or thereabout, although it may differ depending on the kinds of the semi-conductor substrates).

Sputtering process, MBE (Molecular Beam Epitaxy) process, etc., which are expected to be promising for forming a thin film of a high-temperature super-conductive material over a semiconductor substrate, are extremely superior techniques with respect to aligning of crystal orientation, but in both of these processes, since the vapor deposition is effected while the substrate is being heated at a temperature of approximately 800°C, temperature lowering is not sufficiently achieved as desired, with a possibility for the transistors, etc. to be degraded or destroyed.
Patent Abstracts of Japan, Vol.9, No. 321 (E-367) [2044], JP-A-60 154 613 discloses a semiconductor device for ultralow temperature. Furthermore, this document refers to an interconnection method for a semiconductor device, using a superconductive material which does not require an annealing treatment to become superconducting. From "New Electronics", of May 12, 1987, page 30, the use of "high-temperature" super-conductors for electronic devices and the interconnections, which superconductors require an annealing treatment, is known. EP-A-0 285 106 published on October 05, 1988 and EP-A-0 286 106 published on October 12, 1988 both disclose a method of forming a superconducting circuit, comprising the steps of preparing a ceramic body which is changed from a non-superconductive phase, not superconducting at the working temperature, into a superconducting phase, superconducting at the working temperature, by heat-treatment and performing the heat-treatment on a part of the ceramic body by applying a laser beam to the ceramic body to change the same into the superconductive phase, thereby to form a superconducting circuit.
EP-A-0 295 708 published on December 21, 1988 refers to a semiconductor device, having a superconductive wiring. On an IC were the wiring layer is formed of superconductive material, an electrode formed of normal metals, i.e. non-superconductive metals, connects a part of an active semiconductor region via a barrier metal to the superconductive layer wiring at least at the superconductive layer wirings side wall which is essentially orthogonal to the layer wiring.

Accordingly, an essential object of the present invention is to provide a interconnection method for a semiconductor device, in which active elements such as transistors, etc. formed in a lower semiconductor layer of the device are protected against degradation and destruction in the case where interconnections of a superconductive material are to be formed on an interlevel insulation layer.

Another object of the present invention is to provide an interconnection method of the above described type which may be readily introduced into a production line of the semiconductor device at low cost.

In accomplishing these and other objects, according to one embodiment of the present invention, there is provided an interconnection method for a semiconductor device which includes the steps a) to e) as mentioned in claim 1. Further embodiments can be found in the claims being dependant there upon.

By the above method of forming the semiconductor interconnect by the high-temperature superconductive material according to the present invention, the problems described earlier are advantageously solved by annealing the high-temperature superconductive material deposited at the low temperature, through irradiation of the laser beam or electron beam so as to provide the superconductive characteristics, and also to align the crystal orientation, with attention being directed to the fact that transistors, etc. formed on a substrate of the semiconductor device are protected against degradation and destruction by the nature of the annealing through irradiation of such laser beam or electron beam.
Figs. 1(a) to 1(f) are schematic cross sections respectively showing steps of the interconnecting method for a semiconductor according to one preferred embodiment of the present invention.
Fig. 2 is a diagram schematically showing one example of a crystal structure for a high-temperature superconductive material, and
Fig. 3 is a schematic cross section for explaining relation between crystal orientation of the high-temperature superconductive material and interconnecting orientation of the semiconductor device.

Before the description of the present invention proceeds, it is to be noted that like parts are designated by like reference numerals throughout the accompanying drawings.

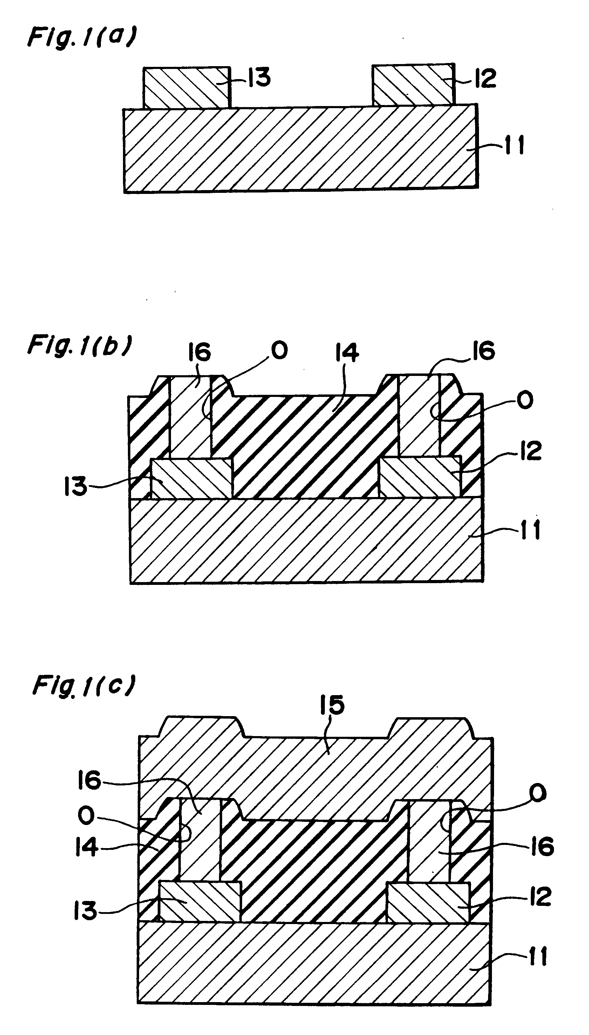

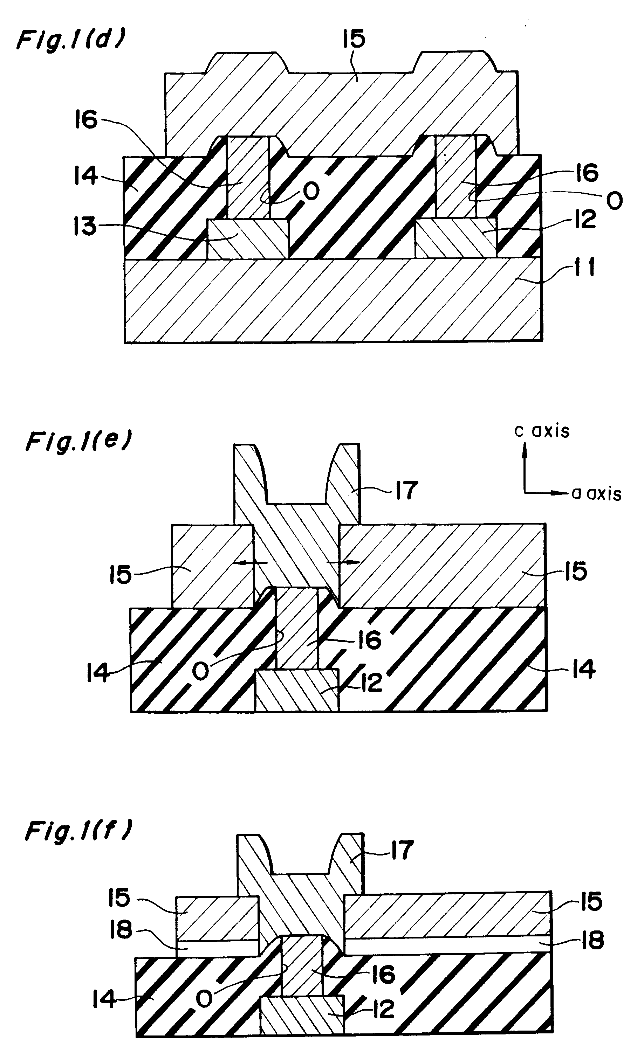

Referring now to the drawings, there are shown in schematic cross sections of Figs. 1(a) to 1(d), steps of an interconnection method for a semiconductor device according to one preferred embodiment of the present invention.

It is to be noted here that, in the drawings to be referred to hereinafter, the case where first level metals are connected by a high-temperature superconductive material will be taken up as example, with parts or portions other than necessary being omitted for brevity of the drawings.

In Fig. 1(a), a semiconductor substrate or base plate 11 has first level metals 12 and 13 formed thereon by a known process, with its lower semiconductor layer being formed with active elements (not shown) such as transistors.

Thereafter, as shown in Fig. 1(b), an interlevel insulation layer 14 of SiO₂ formed by a CVD (chemical vapor deposition) process) is deposited over the substrate 11 having the construction as in Fig. 1(a) by a proper thickness, and through-holes O for connecting the first level metals 12 and 13 with second layer interconnect are formed in the film 14 as shown. The above interlevel insulation layer 14 is formed to have such a thickness as will supply sufficient heat to a high-temperature superconductive material during laser annealing to be described later, while conducting only low heat in a degree not causing degradation or destruction, to transistors, etc. in the lower semiconductor layer of the semiconductor device. (Accordingly, the range for the optimum film thickness is varied by the annealing conditions such as wavelengths, irradiation intensity or irradiating time. It should be noted here that, in the present embodiment, although the above through-holes O are adapted to be filled in by a metallic material 16, some of them may be left open depending on process integration.

Then, as shown in Fig. 1(c), the high-temperature superconductive material 15 is deposited over the entire surface of the semiconductor substrate 11 by any arbitrary method such as sputtering, EB vapor deposition or resistance heating deposition, and although it is not necessary to heat the substrate 11 in this case, the superconductive material is deposited at a composition ratio as will provide the superconductive characteristics after the laser annealing (This ratio is also varied by the annealing conditions).

Subsequently, by the laser annealing, the high-temperature superconductive material 15 deposited over the entire surface of the semiconductor substrate 11 is heat-treated so as to align the crystal orientation as well as to provide the superconductive characteristics at the same time. This is a practice in which the annealing characteristic of laser irradiation is utilized. In other words, in the laser annealing, a short time irradiation in the nanosecond range may be readily effected, and it is possible to complete the whole process of heating and cooling in a time period of microsecond unit, and thus, fast phenomena such as diffusion, segregation, crystal growth, etc. of impurity atoms in the fused material can be fully followed, without giving rise to slow phenomena such as diffusion of impurity atoms in a solid material. In this case, the crystallization of the fused layer and crystal axis orientation may be generally determined only by the annealing condition, without depending on the crystallinity of the ground material. Moreover, by making the thickness of the layer insulating film 14 most suitable for the annealing conditions, the above crystallization can be effected without degrading or destroying the transistors, etc. at the lower layer.

Finally, as shown in Fig. 1(d), unnecessary high-temperature superconductive material 15 is removed by etching, and thus, the semiconductor interconnection is completed.

By the steps as described above, the semiconductor interconnection in which electrical resistance becomes 0 under certain conditions is formed by the superconductive material.

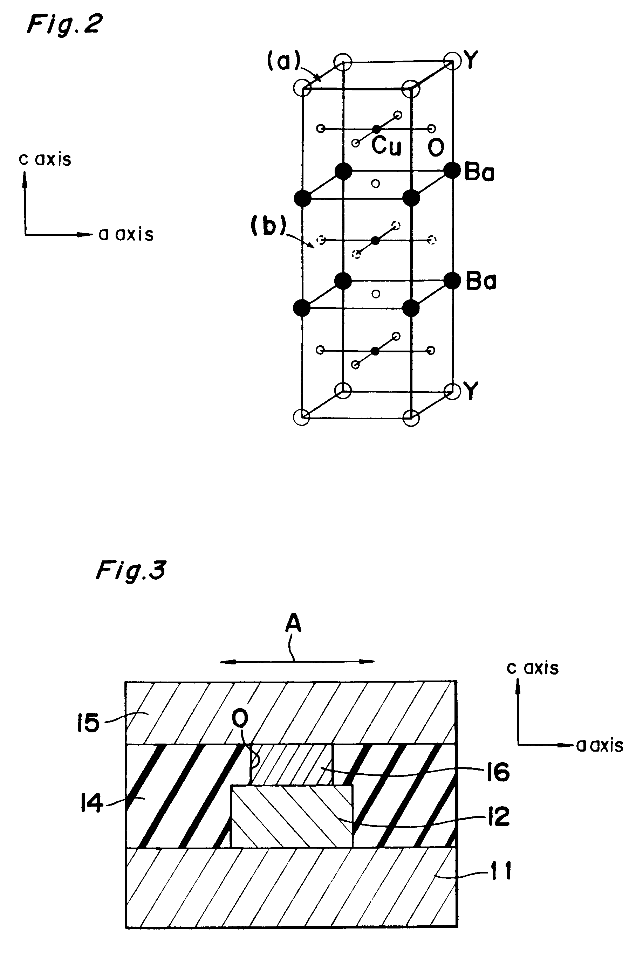

Furthermore, if the foregoing embodiment is further arranged as follows, the present invention becomes more effective.
(i) The high-temperature superconductive material has a crystal structure, for example, as shown in Fig. 2, and since it is governed by the conduction in the a axis orientation due to such crystal structure, it is preferable that the semiconductor interconnection should have the current flowing direction A directed in a direction of the a axis as shown in Fig. 3.
   Accordingly, in a more preferred embodiment of the present invention, as shown in Fig. 1(e), after formation of the interconnection 15 by the superconductive material, contact is formed in a horizontal direction (in the a axis direction) by depositing a metallic material 17 through partial etching of the interconnection on the through-holes O. By the above construction, since the superconduction mainly takes place in the a axis direction, the current may be caused to flow into the interconnection 15 more effectively.
(ii) As shown in Fig. 1(f), by depositing another substance 18 of perovskite group such as SrTiO₃ before deposition of the superconductive material 15, crystallization, etc. at the laser annealing is to be facilitated. It is to be noted here that although SrTiO₃ is a superconductive substance, it has an increased resistance if used at the liquid nitrogen temperature (∼77 K) due to its low critical temperature (∼30 K), and therefore, the substance is to be used together with the method of the above item (i).

As is clear from the foregoing description, according to the present invention, it is possible to form the semiconductor interconnection by the superconductive material in which the electrical resistance becomes 0 under certain conditions, and thus, degradation of the semiconductor devices such as the propagation delay, time at interconnections etc. due to electrical resistance can be advantageously eliminated.

## Claims

1. A method of forming an interconnection wiring of a semiconductor device which comprises the steps of :
a) depositing an interlevel insulation layer (14) made of SiO₂ of a predetermined thickness over a semiconductor substrate (11) formed with active elements therein and with a first level metal (12,13) on its surface;
b) forming through-holes (O) in said interlevel insulation layer (14) and filling at least some of them with a metallic material (16);
c) subsequently depositing over the entire surface of the semiconductor substrate a material (15) which, upon sintering, is capable of becoming superconducting in the vicinity of 77K or higher;
d) annealing said material (15) by means of an electron beam or a laser beam, so as to provide the superconductive characteristics to said material; and
e) removing unnecessary superconducting material (15), so as to form the interconnection wiring.

2. The method of claim 1 further comprising the step of:
c1) forming through-holes in the superconductive material (15) above said through-holes (O) in the interlevel insulation layer (14) by etching and depositing a metallic material (17) in these newly formed through-holes.

3. The method of claim 2 further comprising the step of:
b1) depositing a further layer (18)) made of SrTiO₃ on the interlevel insulation layer (14) before the deposition of the superconductive material (15).

## Patentansprüche

1. Verfahren zur Herstellung einer Verbindungsleitung einer Halbleitervorrichtung, welches die folgenden Schritte umfaßt:
a) Abscheidung einer isolierenden Zwischenschicht (14) aus SiO₂ einer vorherbestimmten Dicke über einem, mit aktiven Bestandteilen hergestelltem und eine metallische erste Schicht (12, 13) an seiner Oberfläche enthaltendem Halbleitersubstrat (11);
b) Bildung von Durchgangslöchern (0) in der isolierenden Zwischenschicht (14) und Auffüllen wenigstens einiger von ihnen mit einem metallischen Material (16);
c) Anschließendes Abscheiden eines Materials (15) über die gesamte Oberfläche des Halbleitersubstrats, welches nach dem Sintern im Bereich von 77 K oder mehr supraleitend werden kann;
d) Tempern des Materials (15) mittels Elektronen- oder Laserstrahl, um so dem Material supraleit-fähige Eigenschaften zu verleihen und
e) Entfernung des überflüssigen supraleitenden Materials (15), um so die Verbindungsleitung herzustellen.

2. Verfahren nach Anspruch 1, das den weiteren Schritt:
c1) Bildung von Durchgangslöchern in dem supraleitfähigen Material (15) über den Durchgangslöchern (0) in der isolierenden Zwischenschicht (14) durch Ätzen und Abscheiden eines metallischen Materials (17) in diesen neu gebildeten Durchgangslöchern
umfaßt.

3. Verfahren nach Anspruch 2, das den weiteren Schritt:
b1) Abscheiden einer weiteren Schicht (18) aus SrTiO₃ auf der isolierenden Zwischenschicht (14) vor dem Abscheiden des supraleitfähigen Materials (15)
umfaßt.

## Revendications

1. Procédé de formation d'un câblage d'interconnexion d'un dispositif semi-conducteur qui comprend les étapes de :
a) dépôt d'une couche d'isolation intermédiaire (14) faite de SiO2 d'une épaisseur prédéterminée sur un substrat semi-conducteur (11) formé d'éléments actifs et avec un métal du premier niveau (12, 13) sur sa surface ;
b) formation de trous de passage (O) dans ladite couche d'isolation intermédiaire (14) et remplissage d'au moins quelques uns d'entre eux par un matériau métallique (16) ;
c) dépôt ultérieur sur la totalité de la surface du substrat semi-conducteur d'un matériau (15) qui, lors du frittage, est capable de devenir supraconducteur au voisinage de 77 K ou plus ;
d) recuit dudit matériau (15) au moyen d'un faisceau d'électrons ou d'un faisceau laser, de façon à procurer les caractéristiques supraconductrices audit matériau ; et
e) enlèvement du matériau supraconducteur superflu (15), de façon à former le câblage d'interconnexion.

2. Procédé selon la revendication 1, comprenant, de plus, l'étape de :
c1) formation de trous de passage dans le matériau supraconducteur (15) au-dessus desdits trous de passage (O) dans la couche d'isolation intermédiaire (14) par attaque chimique et dépôt d'un matériau métallique (17) dans ces trous de passage nouvellement formés.

3. Procédé de la revendication 2, comprenant, de plus, l'étape de :
b1) dépôt d'une couche supplémentaire (18) faite de SrTiO3 sur la couche d'isolation intermédiaire (14) avant le dépôt du matériau supraconducteur (15).
